Europäisches Patentamt

European Patent Office

Office européen des brevets

(19)

(11) **EP 1 338 901 A1**

(12) **EUROPEAN PATENT APPLICATION**

(43) Date of publication:
**27.08.2003 Bulletin 2003/35**

(51) Int Cl.$^7$: **G01R 33/385**

(21) Application number: **03250888.9**

(22) Date of filing: **13.02.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(30) Priority: **20.02.2002 GB 0204023**

(71) Applicant: **Tesla Engineering Limited
Storrington, West Sussex RH20 3EA (GB)**

(72) Inventor: **Goldie, Frederick Thomas David
Worthing, West Sussex BN13 1QW (GB)**

(74) Representative: **Smith, Norman Ian et al
fJ CLEVELAND
40-43 Chancery Lane
London WC2A 1JQ (GB)**

(54) **Gradient coil structure for magnetic resonance imaging**

(57) A coil structure for use as the X or Y gradient coil of an MRIS apparatus. The coil structure comprises two or more linked windings (20, 22), each of which is arranged to produce a selected current distribution. At least some of the current distributions of the windings are adjacent and substantially non-identical and these current distributions when superimposed form the required current distribution.

FIG. 3(a)    FIG. 3(b)    FIG. 3(c)

Printed by Jouve, 75001 PARIS (FR)

EP 1 338 901 A1

**Description**

This invention relates to magnetic coil structures and in particular relates to gradient coil structures for use in Magnetic Resonance Imaging and Spectroscopy (MRIS).

Magnetic Resonance Imaging and Spectroscopy (MRIS) systems generally comprise a plurality of concentric coils which are located around a region within which a patient can be located. The coils include an outermost DC coil which is used to provide a strong constant magnetic field, an inner RF coil arrangement which is arranged concentrically within the DC coil and a gradient coil assembly which is located between the inner RF coil and the outer DC coil. The gradient coil assembly is arranged to generate a time varying audio frequency magnetic field which causes the response frequency of the nuclei of the patient to depend upon their positions within the field.

Gradient coil assemblies usually consist of a set of three coils referred to as the X, Y and Z gradient coils. An unshielded gradient may be formed by winding a pattern of conductors on the surface of a cylinder. Commonly, however, each of the coils is shielded by another pattern of conductors wound on another cylinder which surrounds the gradient coils. In this case, the coils on the first cylinder are referred to as inner or primary coils and the coils on the second cylinder are referred to as outer, secondary or shielding coils.

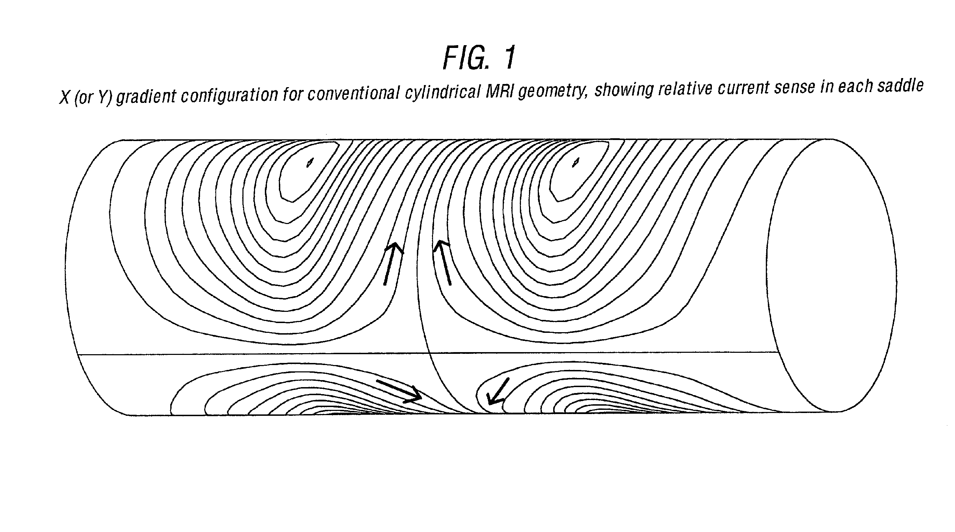

Conventional X and Y inner gradient coils in cylindrical geometry magnets typically comprise four saddle windings each extending angularly slightly less than 180°. They are mounted in symmetrical pairs on either side of a cylinder as indicated in Figure 1 of the drawings. The saddles are connected in such a way as to create a transverse gradient in the axial component of the magnetic field at the centre of the cylinder when current is passed through them. Figure 1 shows the relative sense of the current in each saddle coil.

The shield coils may comprise a further set of four saddle coils mounted on a larger cylinder and located symmetrically around the inner gradient coils. The shield coils minimise magnetic field leakage from the gradient coil into surrounding metallic structures. This minimises the induction of eddy- currents into the metallic structures. Such gradients are known as actively shielded gradients.

There are a number of practical constraints on the design of X and Y gradient coils. They may be limited in length in order to improve patient acceptability or, in the case of small scale head gradients, to accommodate the shoulders of the patient. There can also be limits on the total thickness of the coil structure in parts of the coil circumference. For example, when a coil is designed subject to a length constraint the saddle pattern that results has a very high current density over approximately a 90° sector at its ends. The performance of the coil, that is to say the achievable peak and RMS gradient strength, is limited by the amount of conductor that can be incorporated in the available radial space and also by the efficiency of the cooling means employed.

One well known and commonly employed way of increasing the performance of a coil is to superimpose additional layers of substantially identical windings to form a multi-layered structure. However, if the radial thickness of a coil is limited at any point this method cannot be employed beyond a certain thickness.

In MRIS apparatus there are instances where more radial space is available at some locations on the coil circumference than others. One example is a head gradient coil that has limited space underneath the subject because of the existing means used to support the subject. This means includes a bed support beam and other elements. In other locations, the only constraint is the cylinder enclosing the patient. The present invention proposes a coil structure which can make use of the extra space available in certain regions by adding more conductors in those regions and thereby improving the performance of the coil.

According to the present invention there is provided a coil structure for use as the X or Y gradient coil of an MRIS apparatus, comprising two or more linked windings, each of which is arranged to produce a selected current distribution, at least some of the current distributions being adjacent and substantially non-identical and said current distributions when superimposed forming the required coil current distribution.

The coils may comprise a set of saddle coils. The angular extent of one coil may be greater than that of the other coil or coils.

The coil structure may comprise the X or Y gradient coils of an MRIS apparatus. Additionally or alternatively the coil structure may comprise the shield coils of an MRIS apparatus.

The present coil structure allows a gradient coil to be formed from two or more different coils which can be designed according to the space which is available to accommodate them.

The invention will be described now by way of example only, with particular reference to the accompanying drawings. In the drawings:

Figure 1 is a schematic illustration of a conventional X or Y gradient configuration for an MRIS apparatus.

Figure 2 is a schematic illustration of the concentric coils used in an MRIS apparatus, and Figures 3a to 3c are views illustrating a coil structure in accordance with the present invention.

The embodiment to be described employs cylindrical gradient coils. It should be understood that the invention is applicable to a wide range of alternative geometries, including, but not limited to, planar gradient coils for transverse-field magnetic resonance imaging systems.

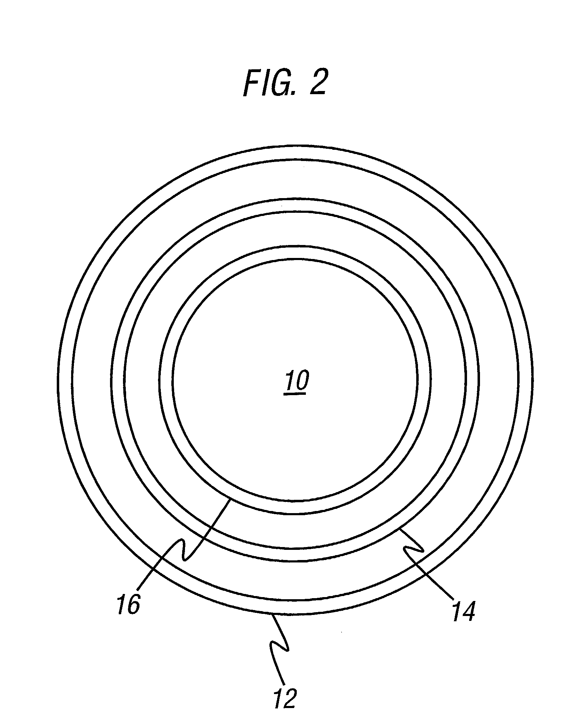

Referring to Figure 2 of the drawings, an MRIS apparatus comprises a cavity (10) within which a patient to be investigated is located. This cavity is surrounded by a number of concentric coil structures. These include an outer DC coil (12) which is normally superconducting and is arranged to provide the main static magnetic field. Located internally of the main coil are gradient coils (14) and within the gradient coils are mounted RF coils (16). The way in which these coils are energized to carry out MRIS is known generally to a person skilled in the art and therefore will not be described here, since it is not necessary for an understanding of the present invention.

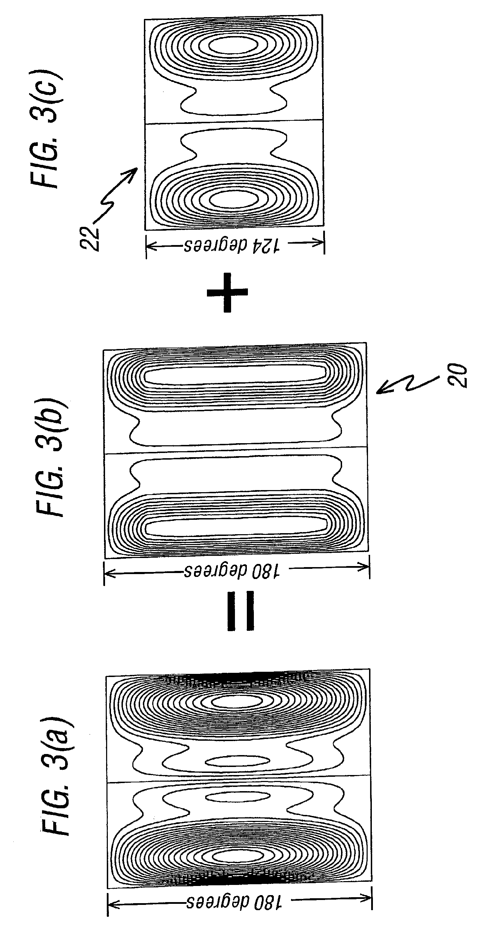

The present embodiment is concerned with the structure of the gradient coils. Instead of using a single set of saddle coil current distributions the present embodiment proposes the provision of two or more substantially non-identical or significantly dissimilar set of saddle coils so arranged that when superimposed they produce the required gradient current distribution. This is illustrated in Figure 3 of the drawings, where Figure 3a shows the required current distribution which as can be seen has a very high current density in certain areas. This can be difficult to achieve with conventional saddle coil arrangements. The present proposal is to achieve this by multiple layers or windings of saddle coils, one (20) of which spans approximately 180° as illustrated in Figure 3b of the drawings and the others (22) of which span a smaller angle (Figure 3c) which can typically be around 120°. By constructing the coils in this way, it is possible to design them so that where there is additional radial space this can accommodate one of the coils illustrated in Figure 3, whilst elsewhere, say at the edges of the 180° saddle, the thickness is not increased. It will be appreciated that Figure 3 of the drawings shows two out of a total of four saddles and that the saddles are shown unwrapped and laid flat. It will be noted that both Figure 3b and 3c have a lower peak current density than that of Figure 3a, and this means that the additional radial space may be used without the need to increase the thickness of the edges of the 180° saddle.

In the arrangement described with reference to Figure 3 the layers or windings are substantially non-identical by having different angular extents. It is thought there may be situations where substantial non-identicality can be achieved by other spatial arrangements.

It will be appreciated that there is considerable freedom to choose how a current is shared between the different saddles. If small effects due to differing radii of the different layers are ignored, the current distribution can be represented by the streamlines of a potential function V ($\phi$,z). The sheet current densities $J_z$, $J_\phi$ are obtainable from V ($\phi$, z) as follows;

$$J_z = \frac{\partial V}{\partial \phi}; \qquad J_\phi = \frac{\partial V}{\partial z}.$$

For an X gradient, it is convenient to consider V($\phi$,z) of the form

$$V(\phi,z) = f(z) \times \sin(\phi) \qquad [f(-z) = -f(z)].$$

(Other forms are possible; the choice of sin($\phi$) modulation minimises undesirable impurities in the gradient).

One possible implementation of the invention would be to replace V($\phi$,z) with two potentials, $V_1(\phi,z)$ and $V_2(\phi,z)$, satisfying the following criteria in the range $-\pi \leq \phi \leq \pi$.

$$V_1(\phi,z) = \frac{f(z)}{2} \times (2.0 \times \sin(\phi) - \sin(1.5 \times \phi)) \qquad [|\phi| < \pi/3]$$

$$V_1(\phi,z) = f(z) \times \sin(\phi) \qquad [|\phi| \geq \pi/3]$$

$$V_2(\phi,z) = \frac{f(z)}{2} \times \sin(1.5 \times \phi) \qquad [|\phi| < \pi/3]$$

$$V_2(\phi,z) = 0 \qquad [|\phi| \geq \pi/3]$$

By adding $V_1(\phi,z)$ and $V_2(\phi,z)$ the original potential V($\phi$,z) may be reconstructed.

However, there are an infinite number of different ways of sharing current between the layers and the one selected will depend on the particular implementation.

It will be appreciated that if the second saddle is designed to span 90° or less, then the invention can be applied to both X and Y gradients, increasing the performance of both, while only using three layers, rather than four, as would otherwise be the case.

The present invention makes it possible to design gradient coils that are thin in important areas, (typically along two opposite principal axes of the coil), but that have greater peak strength and r.m.s. current-carrying capacity than coils that are thin everywhere.

## Claims

1. A coil structure for use as the X or Y gradient coil of an MRIS apparatus, comprising two or more linked windings, each of which is arranged to produce a selected current distribution, at least some of the current distributions being adjacent and substantially non-identical and said current distributions when superimposed forming the required coil current distribution.

2. A coil structure according to claim 1, wherein said coils are a set of saddle coils.

3. A coil structure according to claim 1 or claim 2, wherein the angular extent of one coil is greater than that of the other coil or coils.

4. A gradient coil structure according to claims 1 to 3, wherein the structure comprises the X or Y primary coils of an MRIS apparatus.

5. A gradient coil structure according to any one of claims 1 to 3, wherein the structure comprises the X or Y shield coils of an MRIS apparatus.

6. An MRIS apparatus in which one or both of the X and Y primary gradient coils comprises a coil structure according to any one of claims 1 to 3.

7. An MRIS apparatus according to claim 6 in which one or both of the X and Y shield gradient coils comprises a coil structure according to any of claims 1 to 3.

## FIG. 1

*X (or Y) gradient configuration for conventional cylindrical MRI geometry, showing relative current sense in each saddle*

EP 1 338 901 A1

## FIG. 2

FIG. 3(a)          FIG. 3(b)          FIG. 3(c)

EP 1 338 901 A1

**European Patent Office**

## EUROPEAN SEARCH REPORT

Application Number

EP 03 25 0888

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 372 096 A (SIEMENS AKTIENGESELLSCHAFT) 13 June 1990 (1990-06-13) * page 3, line 14 - page 4, line 33 * * figures 1-6 * | 1-4,6,7 | G01R33/385 |
| X | EP 0 140 259 A (GENERAL ELECTRIC COMPANY) 8 May 1985 (1985-05-08) * page 1, line 1 - line 13 * * page 3, line 36 - page 5, line 24 * * page 7, line 27 - page 9, line 4 * * page 10, line 20 - page 12, line 4 * * page 17, line 11 - page 23, line 33 * * page 24, line 22 - page 25, line 4 * * figures 1-11,17,18 * | 1,2,4-7 | |
| X | US 6 297 635 B1 (W. ARZ ET AL.) 2 October 2001 (2001-10-02) * column 2, line 23 - line 36 * * column 3, line 59 - column 5, line 8 * * figures 1-13 * | 1-7 | |
| | | | TECHNICAL FIELDS SEARCHED (Int.Cl.7) |
| X | EP 0 231 879 A (GENERAL ELECTRIC COMPANY) 12 August 1987 (1987-08-12) * page 3, line 8 - line 23 * * page 4, line 29 - page 11, line 3 * * figures 1-9 * | 1,2,4-7 | G01R |

The present search report has been drawn up for all claims

| Place of search | Date of completion of the search | Examiner |
|---|---|---|
| THE HAGUE | 12 June 2003 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 1 338 901 A1

## ANNEX TO THE EUROPEAN SEARCH REPORT
## ON EUROPEAN PATENT APPLICATION NO.

EP 03 25 0888

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2003

| Patent document cited in search report | | Publication date | Patent family member(s) | | Publication date |
|---|---|---|---|---|---|
| EP 372096 | A | 13-06-1990 | EP | 0372096 A1 | 13-06-1990 |
| | | | JP | 2257937 A | 18-10-1990 |
| | | | US | 5012192 A | 30-04-1991 |
| EP 140259 | A | 08-05-1985 | US | 4646024 A | 24-02-1987 |
| | | | DE | 3484976 D1 | 02-10-1991 |
| | | | EP | 0140259 A2 | 08-05-1985 |
| | | | FI | 843378 A ,B, | 03-05-1985 |
| | | | IL | 72931 A | 30-12-1988 |
| | | | JP | 6028206 B | 13-04-1994 |
| | | | JP | 60132303 A | 15-07-1985 |
| | | | US | 4840700 A | 20-06-1989 |
| | | | KR | 9101860 B1 | 28-03-1991 |
| US 6297635 | B1 | 02-10-2001 | DE | 19851584 C1 | 20-04-2000 |
| | | | GB | 2347505 A | 06-09-2000 |
| | | | JP | 2000139875 A | 23-05-2000 |
| EP 231879 | A | 12-08-1987 | US | 4737716 A | 12-04-1988 |
| | | | DE | 3752332 D1 | 05-07-2001 |
| | | | DE | 3752332 T2 | 18-04-2002 |
| | | | EP | 0231879 A2 | 12-08-1987 |
| | | | EP | 0749017 A1 | 18-12-1996 |
| | | | FI | 870009 A ,B, | 07-08-1987 |
| | | | IL | 80813 A | 21-11-1991 |
| | | | JP | 2108075 C | 06-11-1996 |
| | | | JP | 7114765 B | 13-12-1995 |
| | | | JP | 62194842 A | 27-08-1987 |
| | | | KR | 9000844 B1 | 17-02-1990 |

EPO FORM P0459

For more details about this annex : see Official Journal of the European Patent Office, No. 12/82

9